# EUROPEAN PATENT APPLICATION

(11) **EP 3 907 853 A1**
(43) Date of publication of application: **10.11.2021**
(21) Application number: 20382370.3
(22) Date of filing: 06.05.2020
(51) Int. Cl.: H02J 13/00, G01R 29/18

(54) **SYSTEM AND METHOD FOR IDENTIFYING LINES AND PHASES OF A COMPLEX POWER ELECTRICAL DISTRIBUTION GRID**

(71) Applicant: Merytronic 2012, SL, 48340 Amorebieta (ES)
(72) Inventor: ALDECOA CRUZ, Xabier, 48005 BILBAO (ES)
(74) Representative: Juncosa Miró, Jaime

(57) **Abstract**

System and method for electrical phase and line identification in a complex electrical power distribution grid, comprising a main MV/LV distribution transformer and a plurality of electrical grid distribution centres interconnected between them according to a cascade topology network that creates several electrical levels and provides electrical energy to a plurality of end consumer geographically distributed, the system comprises one hand-held Line Device [LD] allowing to be temporally connected at each end consumer and being configured to perform for each end consumer a specific consumption of electric energy and one stand-alone Central Device [CD] per each of the said plurality of electrical grid distribution centres configured to detect a test signal circulating through the network to discover the electrical pathway of the power network from said main MV/LV distribution transformer to the end consumer identifying the line and phase of each electrical grid distribution centre to which is connected.

## Description

### Technical field

The present invention is directed to the field of electrical phase and line identification in a complex electrical power distribution grid downstream of a main distribution transformer MV/LV and a plurality of electrical grid distribution centres that supplies electrical energy to end consumer.

In this description the word "line" will be used to encompass the feeder or outgoing of any power electrical distribution centre.

### State of the Art

CN109494715 (A) relates to an electrical network topology dynamic identification system and method based on a low-voltage power distribution station area, comprising a station identification terminal of a master, a branch identification terminal of a slave, and a tail end terminal identification terminal of the slave. The station identification terminal is installed on a transformer and the outgoing line terminal is used for transmitting a station identification signal of the station identification terminal and receiving a terminal identification signal of the terminal identification terminal in real time by split-phase broadcasting. The branch identification terminal is installed on the line branch terminal and is used for receiving the real-time station identification signal of the station identification terminal and the end identification signal of the end identification terminal. The end identification terminal is installed at a meter box end and is used for receiving the station identification signal and sending of the station identification terminal in real time.

US 7960964 B2 discloses a method and system for determining a network structure or layout of at least a part of an electricity transport network, the network comprising a number of end-user locations being coupled via electricity transport cables to a plurality of transformer stations and the method comprising providing a test signal to the network at least a first network location and verifying whether said test signal, which has been provided to the first network location, reaches at least a second network location to determine which second network locations are connected to the first network locations thereby determining which end user locations are connected to which transformer stations of the electricity transport network.

The present invention refers to a system and method which has a similar purpose to the two above mentioned antecedents, but based on a different strategy and using other means that are particularly efficient to be implemented in a cascade topology network conceived to create several electrical levels and provide electrical energy to a plurality of end consumer geographically distributed.

### Brief description of the invention

In a fist aspect this invention provides a system for electrical phase and line identification in a complex electrical power distribution grid, comprising a main MV/LV distribution transformer and a plurality of electrical grid distribution centres that are interconnected between them in particular according to a cascade topology network.

The electrical grid distribution centres may comprise substations including at least a Feeder Pillar, a Sub Feeder Pillar, a Mini Feeder Pillar, or a Transformer Station.

The system proposed comprises:
one hand-held Line Device (LD) including an electrical grid reading module and a transmission signal generator (TS), the hand-held Line Device (LD) being designed to be temporally connected at any from a plurality of end consumers and being configured to perform for each end consumer upon generation by said hand-held Line Device (LD) of a specific load at said end consumer, an identification of the line and phase of each electrical grid distribution centre to which said end consumer is connected; and
one stand-alone Central Device (CD) per each of the said plurality of electrical grid distribution centres configured to detect a test signal generated by the transmission signal generator (TS) of the hand-held Line Device (LD), the test signal circulating through the network; and including one transmission module configured to be enabled, i.e. woken up, and to inject an identification signal into the electrical power distribution grid in response of a detection of the cited test signal generated by the transmission signal generator (TS) within a time slot. Besides the one stand-alone Central Device (CD) further including several devices for detecting a current related to said specific load generated by the hand-held Line Device (LD) appearing in one of the phases of one of the lines of each stand-alone Central Device (CD), providing said information to said identification signal. The devices for detecting a current are selected among Rogowski probes, current transformers, shunt resistors, Hall effect sensors or equivalent currents sensors.

According to this structure and arrangement of components upon generation by the hand-held Line Device (LD) of a specific consumption of electric energy at said end consumer (obtained by the insertion or placing of a given load), an electrical two-way communication is established between the transmission signal generator (TS) of the hand-held Line Device (LD) and the transmission module of each stand-alone Central Device (CD). This electrical two-way communication comprises the cited identification signal and the test signal provided by the test signal generator TS of the hand-held Line Device (LD).

In this way the electrical grid reading module of the hand-held Line Device (LD) receives information of a list of lines and phases of all the stand-alone Central Devices (CD) involved in an electrical pathway of the power network from the main MV/LV distribution transformer to the end consumer. The cited list includes each of the stand-alone Central Device (CD) that has detected the test signal.

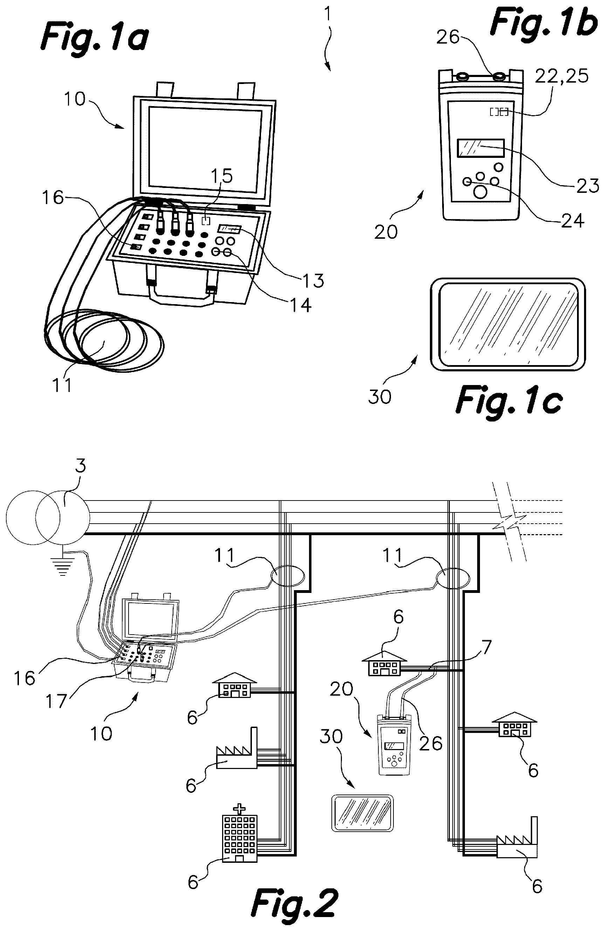

In a second aspect this invention refers to a method for identifying lines and phases of a complex electrical power distribution grid that is implemented in a scenario and with several components as disclosed when explaining the features of the system and then including:
one hand-held Line Device as previously disclosed; and
one stand-alone Central Device (CD) per each of the said plurality of electrical grid distribution centres, configured to detect a test signal generated by the transmission signal generator (TS) circulating through the network; (Fig.1 and 2) and including one transmission module configured to be enabled and to inject an identification signal into the electrical power distribution grid in response of a detection of said test signal generated by the transmission signal generator (TS) within a time slot, and said one stand-alone Central Device (CD) further including several devices for detecting a current related to said specific consumption of electric energy at the end consumer, as a consequence of a load inserted/placed by the hand-held Line Device (LD), appearing in one of the phases of one of the lines of each stand-alone Central Device (CD), providing said information to said identification signal.

The method of this invention is characterized by the following steps:
a) generating a hand-held Line Device (LD) to a final consumer a specific consumption of electric energy, by the addition or insertion of a load at a customer connection point and further generating a test signal which is injected into the electrical grid and which will wake up all the CDs located upstream the customer connection point, from said main MV/LV distribution transformer to the end consumer;
b) measuring all the stand-alone Central Devices (CD), after having been woken up and in a given time slot, an electrical current change resulting of said specific consumption of electric energy and test signal provided at some of its phases and lines;
c) generating all those stand-alone Central Devices (CD) that have measured a current change an identification signal, that is injected in the electrical power distribution grid including information about phase and line of each (CD);
d) receiving by the electrical grid reading module of the hand-held Line Device (LD) said identification signal; and
e) obtaining the hand-held Line Device (LD) from said identification signal sent as a response by several CD information about an electrical pathway from the end consumer to a main MV/LV distribution transformer through several electrical grid distribution centres, identifying in this way for each end consumer to which line and phase of each electrical grid distribution centre it belongs.

According to a preferred embodiment the information about the electrical pathway is shown in a screen of the hand-held Line Device (LD) indicating all the stand alone stand-alone Central Device (CD) that have sent said identification signal.

In an alternative embodiment the information about said electrical pathway is conveyed to at least one adjacent portable device preferably through a wireless communication.

In an alternative embodiment the electrical two-way communication between the transmission signal generator (TS) of the hand-held Line Device (LD) and transmission module of the stand-alone Central Device (CD) is performed through one of the among following technologies: power line communication, radio frequency, cellular communication, electromagnetic waves including microwaves or through optical communication.

In another alternative embodiment the mentioned adjacent portable device includes an integrated APP that is configured to set-up and configure all the different devices that comprises the system to obtain an automatic response of the captured information once discovered the electrical pathway from the end consumer to a main MV/LV distribution transformer through several electrical grid distribution centres. In a particular embodiment this automatic information captured from the integrated APP is related to names and numbers of the different devices that are in the electrical pathway of the grid: distribution centre, feeder pillar, transformer station, user electricity meter that are previously configured or updated. Other features of this invention will be explained with reference to some non-limitative embodiments that are following disclosed.

### Brief description of the Figures

Figs. 1a, 1b and 1c schematically shows the different devices used to implement the method and that define the system of this invention.
Fig. 2 schematically shows a possible electrical connection of one stand-alone Central Device (CD) in a distribution centre substation and the electrical connection of the hand-held Line Device (LD) at end consumer site.
Fig. 3a schematically shows a layout of a plurality of electrical pathways that represents an electrical current flow from the main MV/LV distribution transformer passing through different distribution centres of an embodiment of a cascade level topology and reaching an end consumer.
Fig. 3b schematically shows the screen of the hand-held Line Device (LD) showing the information about the resulting electrical pathway of the test performed at the consumer site.
Fig. 4 schematically shows one embodiment of the top part of the stand-alone Central Device (CD).
Fig. 5 schematically shows one possible embodiment of the hand-held Line Device (LD).

### Detailed description of one embodiment

As previously disclosed the present invention is based on a system for electrical phase and line identification in a complex electrical power distribution grid, comprising as illustrated in Figs. 1a, 1b and 1c, a main MV/LV distribution transformer 3 and a plurality of electrical grid distribution centres 5 interconnected between them in particular according to a cascade topology network that creates several electrical levels and provides electrical energy to a plurality of end consumer 6 geographically distributed.

The electrical grid distribution centres 5 may comprise substations including at least a Feeder Pillar, a Sub Feeder Pillar, a Mini Feeder Pillar, or a Transformer Station.

The system 1 comprises:
one hand-held Line Device (LD) 20 that includes an electrical grid reading module 22 and a transmission signal generator (TS) 25, allowing to be temporally connected to the electrical grid at each end consumer 6 site and being configured to perform for each end consumer 6 under test, a generation of a specific consumption of electric energy (by inserting a given load) at said end consumer 6 an find and identify the line and phase of each electrical grid distribution centre 5 to which said end consumer 6 is connected to; and Fig.1 and 2; and
one stand-alone Central Device (CD) 10 per each of the said plurality of electrical grid distribution centres 5 configured to detect a test signal generated by the transmission signal generator (TS) 25 circulating through the network; Fig.1 and 2 that includes one transmission module 15 configured to be enabled and to inject an identification signal into the electrical power distribution grid in response of a detection of said test signal generated by the transmission signal generator (TS) 25 within a time slot, and said one stand-alone Central Device (CD) 10 further including several devices 11 for detecting a current, in this embodiment are Rogowski proves, that detects the specific load measuring the current of said specific load generated by the hand-held Line Device (LD) 20 appearing in one of the phases of one of the lines of each stand-alone Central Device (CD) 10, providing said information to said identification signal.

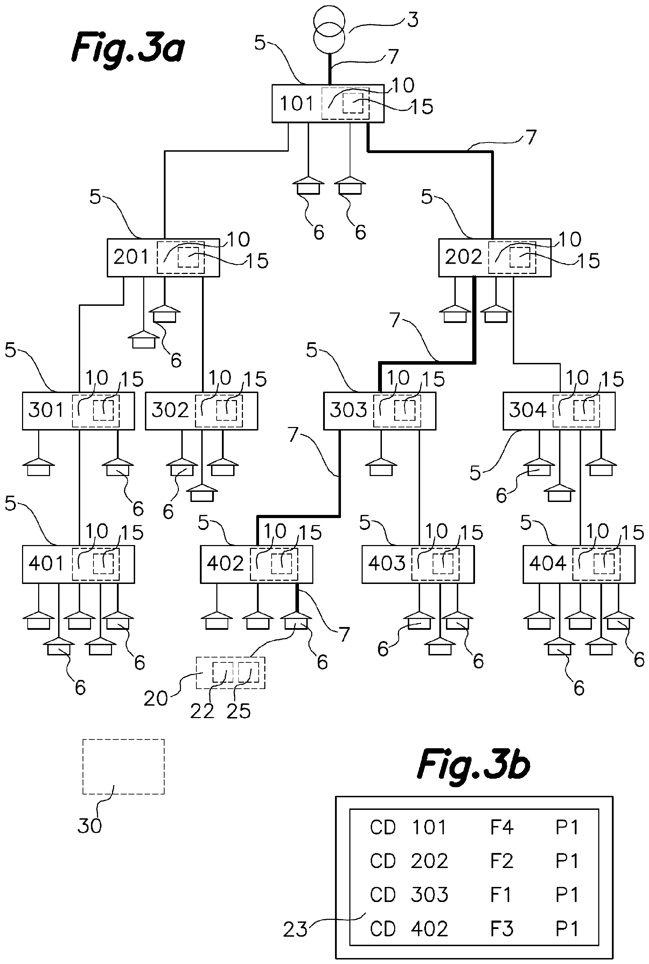

With the above-mentioned interrelated components as explained it turns out that upon generation by said hand-held Line Device (LD) 20 of a specific consumption of electric energy at the end consumer 6, an electrical two-way communication is established between the transmission signal generator (TS) 25 of the hand-held Line Device (LD) 20 and the transmission module 15 of the stand-alone Central Device (CD) 10, said electrical two-way communication comprising said identification signal and the test signal provided by said test signal generator TS of the hand-held Line Device (LD) 20, so that the electrical grid reading module 22 of the hand-held Line Device (LD) 20 receives information of a list of lines and phases of all the stand-alone Central Devices (CD) 10 involved in an electrical pathway 7 of the power network from said main distributing transformer MV/LV to the end consumer 6, said list including each of the stand-alone Central Device (CD) 10 that have detected the test signal Fig.3a and 3b, and

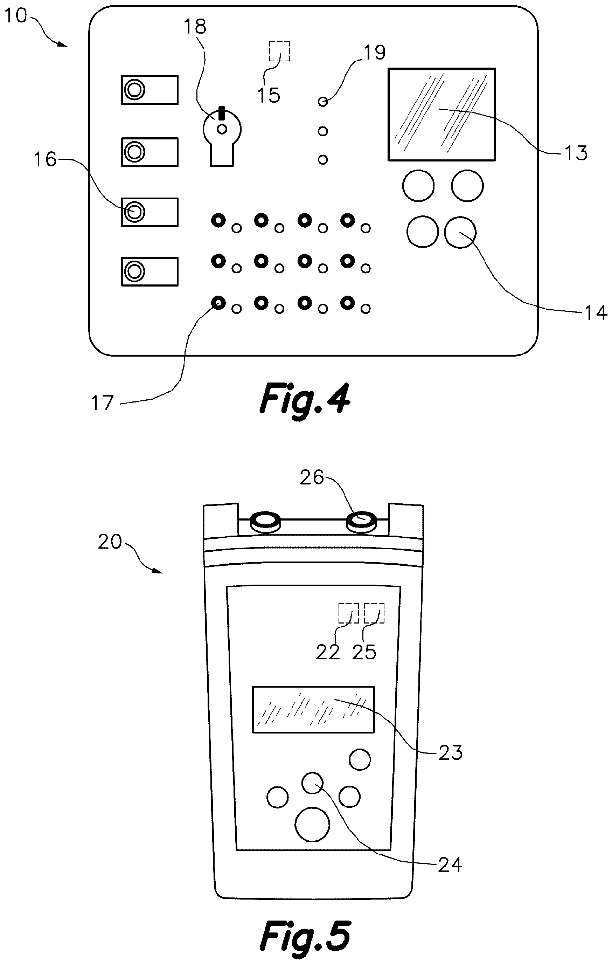

The hand-held Line Device (LD) 20 includes a screen 23 that shows said information of a list of lines and phases of all the stand-alone Central Devices (CD) 10 that have detected the test signal. Further includes pushbuttons 24 to manage its operation including said electrical grid communication module 22. The hand-held Line Device (LD) 20 further includes a wireless communication module configured to transfer the received information of a list of lines and phases of several stand-alone Central Devices (CD) 10 to another adjacent portable device 30 equipped with a global positioning system such as a portable device including a computer or tablet with storage capabilities to store the information received from said electrical grid reading module 22 of said hand-held Line Device (LD) 20 in a geographical information format file and to be later represented by GIS systems when in corrective or preventive maintenance is required. Fig.1 and 5

The hand-held Line Device (LD) 20 intended for being temporally connected to said end consumer 6 is electrically connected by its connections 26 to a phase-phase or to a phase-neutral according to an existing neutral connection at the end consumer 6 site and is electrically self-powered with battery cells or directly powered by the electrical connection established when being connected at the end consumer 6 site by its connections 26. Fig.5

The devices 11 for detecting a current of the stand-alone Central Device (CD) 10 in this embodiment are Rogowski probes that are electrically connected by its device connections 17 and surrounding each phase or the three- phases of every line of each electrical grid distribution centre 5 according to the existing neutral connection. The stand-alone Central Device (CD) 10 is electrically self-powered with battery cells or directly powered by the electrical connection established when performing the tests by its connections 16. Also includes a screen 13 and pushbuttons 14 to manage its operation. Further includes a main on/off switch 18 and LEDs 19. Fig.4

As previously indicated, in a second aspect the invention discloses a method for identifying lines and phases of a complex electrical power distribution grid comprising a main MV/LV distribution transformer and a plurality of electrical grid distribution centres 5 interconnected between them in particular according to a cascade topology network that creates several electrical levels and provides electrical energy to a plurality of end consumer 6 geographically distributed, the cascade topology on which the disclosed embodiment of this invention has been implemented comprises 4 levels starting at level 1 and finishing at level 4,

To implement the method a system as previously explained and including one hand-held Line Device (LD) 20 and one stand-alone Central Device (CD) 10 per each of the said plurality of electrical grid distribution centres 5, and associated components, is used.

The method of this invention is characterized by the following steps:
a) generating a hand-held Line Device (LD) 20 connected to an end consumer 6 a specific consumption of electric energy at the customer connection point and further generates a test signal which is injected into the electrical grid and which will wake up all the CDs located upstream the customer connection point, from said main distributing transformer MV/LV to the end consumer 6;
b) generating the stand-alone Central Device (CD) (10), of a corresponding level, starting at level 1 and finished at level 4, (10) an identification signal, that is injected in the electrical power distribution grid into the including information about phase;
c) measuring all the stand-alone Central Devices (CD) 10, after having been woken up and in a given time slot, an electrical current change resulting of said specific load inserted at a costumer connection point and test signal provided at some of its phases and lines;
d) generating all those stand-alone Central Devices (CD) (10), that have measured a current change an identification signal, that is injected in the electrical power distribution grid including information about phase and line of each stand-alone Central Device (CD) (10);
e) receiving by the electrical grid reading module 22 of the hand-held Line Device (LD) 20 said identification signal;
f) obtaining the reading module 22 of hand-held Line Device (LD) 20, from said identification signal information about an electrical pathway 7 from the end consumer 6 to a main MV/LV distribution transformer 3 through several electrical grid distribution centres 5, identifying in this way for each end consumer 6 to which line and phase of each electrical grid distribution centre 5 it belongs, and
g) optionally showing information in a screen about all the stand alone stand-alone Central Device (CD) 10 that have sent said identification signal.

In an embodiment the information about said electrical pathway 7 is conveyed to at least one adjacent portable device 30 (see Fig.1c), preferably through a wireless communication.

Also, according to an embodiment, the information about said electrical pathway 7 is checked against a GPS system to provide a map of said electrical pathway and showing and/or storing said map.

## Claims

1. System (1) for electrical phase and line identification in a complex electrical power distribution grid, comprising a main MV/LV distribution transformer (3) and a plurality of electrical grid distribution centres (5) interconnected between them in particular according to a cascade topology network that creates several electrical levels and provides electrical energy to a plurality of end consumer (6) geographically distributed, the system (1) comprising:
one hand-held Line Device [LD] (20) including an electrical grid reading module (22) and a transmission signal generator [TS] (25), the hand-held Line Device [LD] (20) allowing to be temporally connected at each end consumer (6) and being configured to perform for each end consumer (6) upon generation by said hand-held Line Device [LD] (20) a specific consumption of electric energy, by the insertion of a load at said end consumer 6, an identification of the line and phase of each electrical grid distribution centre (5) to which said end consumer 6 is connected; and (Fig.1 and 2); and
one stand-alone Central Device [CD] (10) per each of the said plurality of electrical grid distribution centres (5) configured to detect a test signal generated by the transmission signal generator [TS] (25) circulating through the network; (Fig.1 and 2) and including one transmission module (15) configured to be enabled and to inject an identification signal into the electrical power distribution grid in response of a detection of said test signal generated by the transmission signal generator [TS] (25) within a time slot, and said one stand-alone Central Device [CD] (10) further including several devices (11) for detecting a current related to said specific consumption of electric energy generated by the hand-held Line Device [LD] (20) appearing in one of the phases of one of the lines of each stand-alone Central Device [CD] (10), providing said information to said identification signal,
whereby upon generation by said hand-held Line Device [LD] (20) of said specific consumption of electric energy at said end consumer 6, an electrical two-way communication is established between the transmission signal generator [TS] (25) of the hand-held Line Device [LD] (20) and the transmission module (15) of the stand-alone Central Device [CD] (10), said electrical two-way communication comprising said identification signal and the test signal provided by said test signal generator TS of the hand-held Line Device [LD] (20), so that the electrical grid reading module (22) of the hand-held Line Device [LD] (20) receives information of a list of lines and phases of all the stand-alone Central Devices [CD] (10) involved in an electrical pathway (7) of the power network from said main MV/LV distribution transformer to the end consumer (6), said list including each of the stand-alone Central Device [CD] (10) that have detected the test signal (Fig.3a and 3b), and
wherein the electrical grid distribution centres (5) may comprise substations including at least a Feeder Pillar, a Sub Feeder Pillar, a Mini Feeder Pillar, or a Transformer Station.

2. System (1) according to claim 1, wherein said devices (11) for detecting a current related to said specific consumption of electric energy generated by the hand-held Line Device [LD] (20) are selected among Rogowski probes, current transformers, shunt resistors or Hall effect sensors.

3. System (1) according to the previous claims wherein said electrical two-way communication between the transmission signal generator [TS] (25) of the hand-held Line Device [LD] (20) and transmission module (15) of the stand-alone Central Device [CD] (10) is performed through power line communication, via radio frequency, via cellular communication, by electromagnetic waves including microwaves or through optical communication.

4. System (1) according to claim 1, wherein said hand-held Line Device [LD] (20) includes a screen (23) that shows said information of a list of lines and phases of all the stand-alone Central Devices [CD] (10) that have detected the test signal. (Fig.5)

5. System (1) according to claim 1, wherein said hand-held Line Device [LD] (20) further includes pushbuttons (24) to manage its operation including said electrical grid communication module (22). (Fig.5)

6. System (1) according to claim 1, wherein said hand-held Line Device [LD] (20) further includes a wireless communication module configured to transfer the received information of a list of lines and phases of several stand-alone Central Devices [CD] (10) to another adjacent portable device (30) equipped with a global positioning system. (Fig.1)

7. System (1) according to claim 1, wherein said hand-held Line Device [LD] (20) intended for being temporally connected to said end consumer (6) is electrically connected to a phase-phase or to a phase-neutral according to an existing neutral connection at the end consumer (6) site.

8. System (1) according to claim 1, wherein said hand-held Line Device [LD] (20) intended for being temporally connected to said end consumer (6) is electrically self-powered with battery cells or directly powered by the electrical connection established when being connected at the end consumer (6) site.

9. System (1) according to claim 1, wherein said devices (11) for detecting a current of the stand-alone Central Device [CD] (10) are electrically connected surrounding each phase or the three-phases of every line of each electrical grid distribution centre (5) according to the existing neutral connection.

10. System (1) according to claim 1, wherein said stand-alone Central Device [CD] (10) is electrically self-powered with battery cells or directly powered by the electrical connection established when performing the tests.

11. System (1) according to claim 1, wherein said stand-alone Central Device [CD] (10) further includes pushbuttons (14) to manage its operation. (Fig.4)

12. System (1) according to claim 6, wherein said another adjacent portable device (30) is a portable device including a computer or tablet with storage capabilities to store the information received from said electrical grid reading module (22) of said hand-held Line Device [LD] (20) in a geographical information format file.

13. Method for identifying lines and phases of a complex electrical power distribution grid comprising a main MV/LV distribution transformer (3) and a plurality of electrical grid distribution centres (5) interconnected between them in particular according to a cascade topology network that creates several electrical levels and provides electrical energy to a plurality of end consumer (6) geographically distributed, wherein the method uses a system that comprises:
one hand-held Line Device [LD] (20) including an electrical grid reading module (22) and a transmission signal generator [TS] (25), the hand-held Line Device [LD] (20) allowing to be temporally connected at each end consumer (6) and being configured to perform for each end consumer (6) upon generation by said hand-held Line Device [LD] (20) a specific consumption of electric energy by the insertion of a load at said end consumer (6), an identification of the line and phase of each electrical grid distribution centre (5) to which said end consumer (6) is connected; and (Fig.1 and 2); and
one stand-alone Central Device [CD] (10) per each of the said plurality of electrical grid distribution centres (5) configured to detect a test signal generated by the transmission signal generator [TS] (25) circulating through the network; (Fig.1 and 2) and including one transmission module (15) configured to be enabled and to inject an identification signal into the electrical power distribution grid in response of a detection of said test signal generated by the transmission signal generator [TS] (25) within a time slot, and said one stand-alone Central Device [CD] (10) further including several devices (11) for detecting a current related to said specific consumption of electric energy generated by the hand-held Line Device [LD] (20) appearing in one of the phases of one of the lines of each stand-alone Central Device [CD] (10), providing said information to said identification signal,
and wherein the method is **characterized by** the following steps:
a) generating a hand-held Line Device [LD] 20 connected to an end consumer (6) a specific consumption of electric energy at the customer connection point and further generates a test signal which is injected into the electrical grid and which will wake up all the CDs located upstream the customer connection point, from said main MV/LV distribution transformer (3) to the end consumer (6);
b) measuring all the stand-alone Central Devices [CD] (10), after having been woken up and in a given time slot, an electrical current change resulting of said specific consumption of electric energy and test signal provided at some of its phases and lines;
c) generating all those CD that have measured a current change an identification signal, that is injected in the electrical power distribution grid including information about phase and line of each CD;
d) receiving by the electrical grid reading module (22) of the hand-held Line Device [LD] (20) said identification signal;
e) obtaining the LD (22) from said identification signal information about an electrical pathway (7) from the end consumer (6) to a main MV/LV distribution transformer (3) through several electrical grid distribution centres (5), identifying in this way for each end consumer (6) to which line and phase of each electrical grid distribution centre (5) it belongs, and
f) optionally showing information in a screen about all the stand alone stand-alone Central Device [CD] (10) that have sent said identification signal.

14. Method according to claim 13, wherein the information about said electrical pathway (7) is conveyed to at least one adjacent portable device (30), preferably through a wireless communication.

15. Method according to claim 14, wherein the information about said electrical pathway (7) is checked against a GPS system to provide a map of said electrical pathway and showing and/or storing said map.
